# EUROPEAN PATENT APPLICATION

(11) **EP 2 787 525 A1**
(43) Date of publication of application: **08.10.2014**
(21) Application number: 14151309.3
(22) Date of filing: 15.01.2014
(51) Int. Cl.: H01L 21/20

(54) **Substrate structures and semiconductor devices employing the same**

(30) Priority: 05.04.2013 KR 20130037654
(71) Applicant: Samsung Electronics Co., Ltd, Gyeonggi-do 443-742 (KR)
(72) Inventor: Lee, Sang-moon, 449-712 Gyeonggi-do (KR); Cho, Young-jin, 449-712 Gyeonggi-do (KR); Lee, Myong-jae, 449-712 Gyeonggi-do (KR)
(74) Representative: Zijlstra, Robert Wiebo Johan

(57) **Abstract**

A substrate structure includes a substrate, a nucleation layer on the substrate and including a group III-V compound semiconductor material having a lattice constant that is different from that of the substrate by less than 1%, and a buffer layer on the nucleation layer and including first and second layers, wherein the first and second layers include group III-V compound semiconductor materials having lattice constants that are greater than that of the nucleation layer by 4% or more.

## Description

### FIELD OF THE INVENTION

Example embodiments to relate to substrate structures for forming a high quality Group III-V compound semiconductor with less defects, and semiconductor devices employing the same.

### BACKGROUND OF THE INVENTION

Research activities are currently being conducted in a wide range of fields to replace a silicon (Si) semiconductor material by using a compound semiconductor, and in particular, a group III-V compound semiconductor material. Because a group III-V compound semiconductor material has an electron mobility that is 10 to 10³ times higher than that of Si, the group III-V compound semiconductor material is suitable as a channel of a high-speed element in a Complementary Metal Oxide Semiconductor (CMOS) device or for use in high efficiency group III-V compound solar cells.

Group III-V compound substrates made of group III-V compound semiconductors such as indium phosphide (InP), gallium arsenide (GaAs), gallium antimonide (GaSb), and indium antimonide (InSb) have been widely used as substrates for growing group III-V compound semiconductor materials. However, these substrates are over 20 times more expensive than Si substrates, and are so hard that they can be easily broken during a manufacturing process. At present, because the maximum diameter of commercially available substrates is 6 inches, it may be difficult to manufacture a large-area substrate. To overcome these limitations, a semiconductor device using a Si substrate instead of a group III-V compound substrate is being developed.

Furthermore, as much attention is being directed toward a technology for realizing Si-based photonics integrated circuits, the demand for a technique of forming light sources such as light emitting diodes (LEDs) and laser diodes (LDs) and transistors for high-speed devices on a Si substrate is increasing. Integration of group III-V compound semiconductors on a large-area Si substrate may not only allow the use of the existing silicon manufacturing process but may also significantly reduce the manufacturing cost.

However, due to large differences in lattice constants and thermal expansion coefficients between a group III-V compound semiconductor material and a silicon substrate, various defects may occur, thereby imposing limitations on its application to device. For example, if a semiconductor thin film with a smaller lattice constant than that of a substrate is grown, dislocations may occur due to compressive stresses. On the other hand, if a semiconductor thin film with a larger lattice constant than that of a substrate is grown, cracks may be caused due to tensile stresses. To solve these problems, various buffer layer structures are being proposed for growing a Group III-V compound semiconductor thin film having high crystallinity without defects such as cracks or dislocations on a Si substrate.

### SUMMARY OF THE INVENTION

Provided are substrate structures for forming a high quality group III-V compound semiconductor with less defects and semiconductor devices employing the same.

Additional example embodiments will be set forth in part in the description which follows and, in part, will be apparent from the description, or may be learned by practice of the presented example embodiments.

According to example embodiments, a substrate structure includes a substrate, a nucleation layer on the substrate and including a first group III-V compound semiconductor material having a lattice constant that is different from a lattice constant of the substrate by less than 1%, and a buffer layer on the nucleation layer and including first and second layers. The first layer includes a second group III-V compound semiconductor material, and the second layer includes a third group III-V compound semiconductor material. The second group III-V compound semiconductor material and the third group III-V compound semiconductor material have lattice constants that are greater than the lattice constant of the first group III-V compound semiconductor material included in the nucleation layer by 4% or more.

The nucleation layer may have a lattice constant different from the lattice constant of the substrate by less than 1%. The first and second layers may have lattice constants greater than the lattice constant of the nucleation layer by 4% or more.

A difference between lattice constants of the first and second layers of the buffer layer may be less than 1%. The buffer layer may further include a third layer on the second layer. The third layer may include a fourth group III-V compound semiconductor material having a lattice constant that is different from the lattice constant of the third group III-V compound semiconductor material included in the second layer by less than 1%.

The third layer may have a lattice constant different from a lattice constant of the second layer by less than 1%.

The third group III-V compound semiconductor material may be the same as the fourth group III-V compound semiconductor material.

The second layer may be made of the third group III-V compound semiconductor material. The third layer may be made of the fourth group III-V compound semiconductor material. A group V element in the third group III-V compound semiconductor material may be different from a group V element in the fourth group III-V compound semiconductor material.

The buffer layer may have a structure in which the second and third layers are alternately stacked at least two times on each other.

The buffer further may include a material layer at an interface between the second and third layers. A difference between a lattice constant of the material layer and a lattice constant of the second layer may be larger than a difference between the lattice constant of the second layer and the lattice constant of the third layer. A difference between the lattice constant of the material layer and a lattice constant of the third layer may be larger than the difference between the lattice constant of the second layer and the lattice constant of the third layer.

One of the second and third layers may be indium phosphide (InP), and the other one may be indium gallium arsenide (InGaAs).

The first layer may be made of the second group III-V compound semiconductor material. The second layer may be made of the third group III-V compound semiconductor material. A group V element in the second group III-V compound semiconductor material may be different from a group V element in the third group III-V compound semiconductor material.

The buffer layer may have a structure in which the first and second layers are alternately stacked at least two times on each other.

The buffer layer further may include a material layer at an interface between the first and second layers. A difference between a lattice constant of the material layer and the lattice constant of the first layer may be larger than the difference between the lattice constant of the first layer and the lattice constant of the second layer. A difference between the lattice constant of the material layer and the lattice constant of the second layer may be larger than the difference between the lattice constant of the first layer and the lattice constant of the second layer.

One of the first and second layers may be InP, and the other one may be InGaAs.

The nucleation layer may include at least one selected from the group consisting of gallium phosphide (GaP), aluminum phosphide (AIP), gallium aluminum phosphide (GaₓAl₁₋ₓP,), gallium nitrogen phosphide (GaNP), and gallium nitrogen arsenic phosphide (GaNAsP).

The buffer layer may be formed of one selected from the group consisting of InP, gallium arsenide (GaAs), indium arsenide (InAs), gallium antimonide (GaSb), and indium antimonide (InSb), and a combination thereof.

The substrate may be a silicon substrate.

According to example embodiments, a semiconductor device includes a silicon substrate, and a nucleation layer on the silicon substrate. The nucleation layer includes a first group III-V compound semiconductor material having a lattice constant different from a lattice constant of the substrate by less than 1%. The semiconductor device further includes a buffer layer on the nucleation layer and including first and second layers. The first layer includes a second group III-V compound semiconductor material and the second layer includes a third group III-V compound semiconductor material. The second group III-V compound semiconductor material and the third group III-V compound semiconductor material have lattice constants that are greater than the lattice constant of the first group III-V compound semiconductor material in the nucleation layer by 4% or more. The semiconductor device further includes a device layer on the buffer layer, wherein the device layer includes a group III-V compound semiconductor layer.

The device layer may include one selected from the group consisting of a light emitting diode (LED), a laser diode (LD), a photo diode (PD), a field effect transistor (FET), a high electron mobility transistor (HEMT), and a Schottky diode structure.

The semiconductor device may further include a silicon-based electronic device or optical device on the silicon substrate.

A difference between lattice constants of the first and second layers in the buffer layer may be less than 1%.

The buffer layer may further include a third layer on the second layer. The third layer may include a fourth group III-V compound semiconductor material having a lattice constant that is different from the third group III-V compound semiconductor material in the second layer by less than 1%.

According to example embodiments, a semiconductor substrate includes a stack of at least three semiconductor layers on a substrate. Each of the at least three semiconductor layers includes a group III-V compound semiconductor material having a lattice constant different than the lattice constant of the group III-V compound semiconductor material in the semiconductor layer thereunder. The difference in lattice constant between the at least three semiconductor layers decreases the further the at least three semiconductor layers are from the substrate.

The group III-V compound semiconductor material in each of at least three semiconductor layers may have a group V element different than the group V element of the group III-V compound semiconductor material in the semiconductor layer thereunder.

The substrate may be a silicon substrate, a first layer of the at least three semiconductor layers may include a first group III-V compound semiconductor material having a lattice constant different from a lattice constant of the substrate by less than about 1%, a second layer of the at least three semiconductor layers may include a second group III-V compound semiconductor material, a third layer of the at least three semiconductor layers may include a third group III-V compound semiconductor material. The second and third group III-V compound semiconductor materials each may have lattice constants greater than the lattice constant of the first group III-V compound semiconductor material by about 4% or more.

A difference in the lattice constants of the second and third group III-V compound semiconductor materials may be less than about 1%.

The semiconductor substrate may further include a first material layer between the first layer and the second layer. A difference in a lattice constant of the first material layer and the lattice constant of the first layer may be larger than a difference in the lattice constant of the first layer and the lattice constant of the second layer. A difference in the lattice constant of the first material layer and the lattice constant of the second layer may be larger than the difference in the lattice constant of the first layer and the lattice constant of the second layer.

The second and third layers may be alternately stacked on the first layer.

The first group III-V compound semiconductor material may be gallium phosphide (GaP), the second group III-V compound semiconductor material may be indium phosphide (InP), and the third group III-V compound semiconductor material may be indium gallium arsenide (InGaAs).

### BRIEF DESCRIPTION OF THE DRAWINGS

These and/or other example embodiments will become apparent and more readily appreciated from the following description of the embodiments, taken in conjunction with the accompanying drawings of which:
FIG. 1 is a schematic cross-sectional view of a substrate structure according to example embodiments;
FIG. 2 is a schematic cross-sectional view of a substrate structure according to other example embodiments;
FIG. 3 is a schematic cross-sectional view of a substrate structure according to still other example embodiments;
FIG. 4 is a schematic cross-sectional view of a substrate structure according to further example embodiments;
FIG. 5 is a schematic cross-sectional view of a semiconductor device according to example embodiments;
FIG. 6 is a schematic cross-sectional view of a semiconductor device according to other example embodiments;
FIG. 7 is a schematic cross-sectional view of a semiconductor device according to still other example embodiments; and
FIG. 8 is a schematic cross-sectional view of a semiconductor device according to further example embodiments.

### DETAILED DESCRIPTION OF THE EMBODIMENTS

Example embodiments to relate to substrate structures for forming a high quality Group III-V compound semiconductor with less defects, and semiconductor devices employing the same.

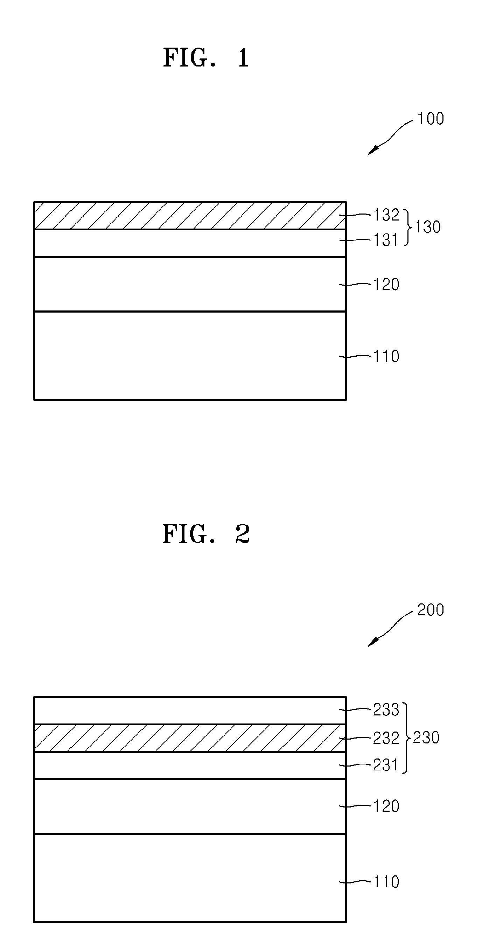

FIG. 1 is a cross-sectional view of a substrate structure according to example embodiments.

Referring to FIG. 1, a substrate structure 100 includes a substrate 110, a nucleation layer 120 formed on the substrate 110, and a buffer layer 130 formed on the nucleation layer 120. The substrate structure 100 may serve as a template for forming a compound semiconductor layer having a largely different lattice constant from that of the substrate 110 on the substrate 110 with slight defects. For example, when the substrate 110 is a silicon substrate, and a group III-V compound semiconductor layer is formed on the silicon substrate 110, the group III-V compound semiconductor layer undergoes a compressive stress from the silicon substrate to thereby cause defects such as dislocations. The substrate structure 100 is configured so that defects such as dislocations concentrate in the buffer layer 130 on the nucleation layer 120 and interact and annihilate each other, thereby reducing the occurrence of defects in a compound semiconductor layer which will be subsequently formed thereon.

The nucleation layer 120 may have a similar lattice constant to that of the substrate 110. For example, the nucleation layer 120 may be formed of a group III-V compound semiconductor material with a lattice constant that differs by less than 1% from that of the substrate 110. When the substrate 110 is a silicon substrate, and the nucleation layer 120 is made of gallium phosphide (GaP), a difference between lattice constants of the substrate 110 and the nucleation layer 120 is approximately 0. 2%. The nucleation layer 120 may include one of GaP, aluminum phosphide (AIP), gallium aluminum phosphide (GaₓAl₁₋ₓP,), gallium nitrogen phosphide (GaNP), and gallium nitrogen arsenic phosphide (GaNAsP).

The buffer layer 130 may include a first layer 131 and a second layer 132, which have largely different lattice constants from that of the nucleation layer 120. For example, the first and second layers 131 and 132 may be formed of group III-V compound semiconductor materials having lattice constants that are different from that of the nucleation layer 120 by 4% or more. The first and second layers 131 and 132 may have a lattice constant larger than that of nucleation layer 120. The first and second layers 131 and 132 have similar lattice constants to each other, and a lattice constant difference between the first and second layers 131 and 132 may be less than about 1%. Each of the first and second layers 131 and 132 in the buffer layer 130 may be formed of one of GaP, indium phosphide (InP), gallium arsenide (GaAs), indium arsenide (InAs), gallium antimonide (GaSb) and indium antimonide (InSb), or a combination thereof. Each of the first and second layers 131 and 132 in the buffer layer 130 may be formed of at least one of gallium (Ga), phosphorus (P), As, In and Sb.

Each of the first and second layers 131 and 132 may be made of a group III-V compound semiconductor material, wherein a group V element included in the first layer 131 is different from a group V element included in the second layer 132. For example, one of the first and second layers 131 and 132 may be made of InP, and the other one may be made of indium gallium arsenide (InGaAs).

As described above, the nucleation layer 120 has a similar lattice constant to that of the substrate 110, and the buffer layer 130 is formed of a material having a largely different lattice constant from that of the substrate 110. This is to form the nucleation layer 120 having a uniform thickness and little defects and to concentrate defects resulting from a lattice constant difference in the buffer layer 130 formed on the nucleation layer 120. The defects concentrated in the buffer layer 130 may counterbalance and annihilate each other as described in detail below.

FIG. 2 is a schematic cross-sectional view of a substrate structure according to other example embodiments.

In substrate structure 200 according to the present example embodiments, a buffer layer 230 includes first and second layers 231 and 232 having lattice constants that are different from that of the nucleation layer 120 by about 4% or more, and a third layer 233 made of a group III-V compound semiconductor material having a lattice constant that is different from that of the second layer 232 by less than 1 %. Each of the second and third layers 232 and 233 may be made of a group III-V compound semiconductor material, wherein a Group V element included in the second layer 232 is different from a Group V element included in the third layer 233. For example, one of the first and second layers 231 and 232 may be made of InP, and the other one may be made of InGaAs. The third layer 233 may also be formed of the same group III-V compound semiconductor material as the first layer 231.

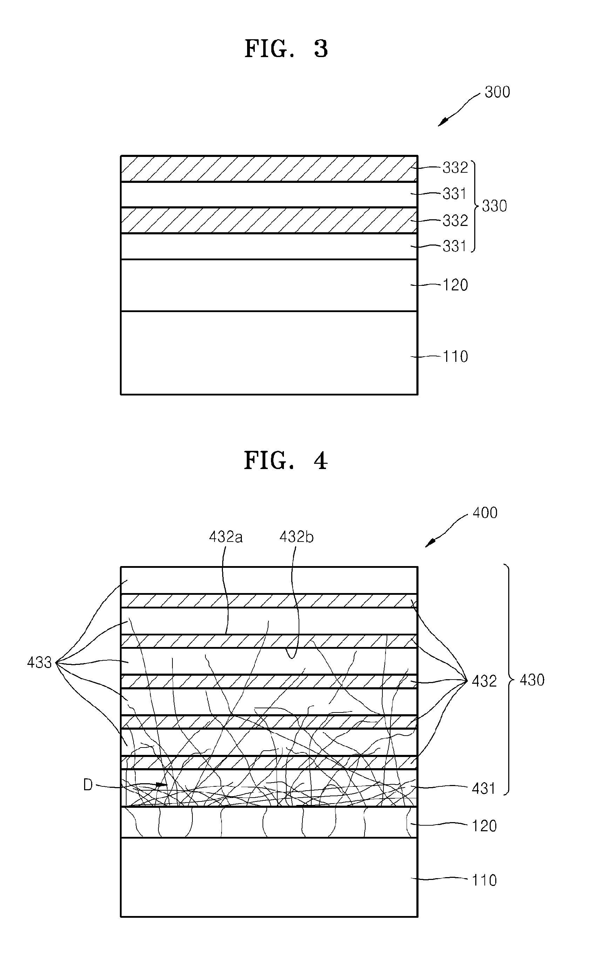

FIG. 3 is a schematic cross-sectional view of a substrate structure according to still other example embodiments.

Referring to FIG. 3, in a substrate structure 300 according to the present example embodiments, a buffer layer 330 is formed on the nucleation layer 120 and includes two pairs of first and second layers 331 and 332 alternately stacked. The first and second layers 331 and 332 may have lattice constants that are different from that of the nucleation layer 120 by about 4% or more and different from each other by less than 1%. Each of the first and second layers 331 and 332 may be made of a group III-V compound semiconductor material, wherein a group V element included in the first layer 331 is different from a group V element included in the second layer 332. The number of times at which the first and second layers 331 and 332 are alternately stacked on each other is not limited to 2. In this structure, a material layer (not shown) is formed at an interface between the first and second layers 331 and 332, wherein a difference between a lattice constant of the material layer and the lattice constant of the first layer 331 and a difference between the lattice constant of the material layer and a lattice constant of the second layer 332 are each larger than a difference between the lattice constant of the first layer 331 and the lattice constant of the second layer 332. The material layer prevents dislocations from propagating upward.

FIG. 4 is a schematic cross-sectional view of a substrate structure according to further example embodiments.

Referring to FIG. 4, a substrate structure 400 according to the present example embodiments includes a nucleation layer 120, a first layer 431 formed on the nucleation layer 120, and a buffer layer 430 formed on the first layer 431. In this case, second and third layers 432 and 433 are alternately stacked, for example, at least five times on each other to thereby form the buffer layer 430.

The first layer 431 is made of a group III-V compound semiconductor material having a lattice constant that is different from that of the nucleation layer 120 by about 4% or more. The second layer 432 is made of a group III-V compound semiconductor material having a lattice constant that is different from that of the first layer 431 by less than 1 %, and the third layer 433 is made of a group III-V compound semiconductor material having a lattice constant that is different from that of the second layer 432 by less than 1 %. Each of the second and third layers 432 and 433 may be formed of a group III-V compound semiconductor material, wherein a group V element included in the second layer 432 is different from a group V element included in the third layer 433.

The first and third layers 431 and 433 may be formed of the same group III-V compound semiconductor material.

The number of times at which the second and third layers 432 and 433 are alternately stacked on each other is not limited to 5, and may be changed. The number of times may be properly determined by considering the degree to which defects decrease upward as the number of times varies. When the second and third layers 432 and 433 of Group III-V compound semiconductor materials, each containing a different Group V material, are alternately stacked, a material layer (not shown) may be formed at an interface between the second and third layers 432 and 433 so as to prevent propagation of dislocations from an underlying layer into overlying layers. Because a difference between a lattice constant of the material layer and the lattice constant of the second layer 432 and a difference between the lattice constant of the material layer and the lattice constant of the third layer 433 are each larger than a difference between the lattice constant of the second layer 432 and the lattice constant of the third layer 433, the material layer may prevent dislocations from propagating upward. For example, if the second and third layers 432 and 433 are formed of InGaAs and InP, respectively, a material layer of indium gallium arsenic phosphide (InGaAsP) and a material layer of indium arsenic phosphide (InAsP) may be formed to nanometer thicknesses at an interface 432a above the second layer 432 and an interface 432b below the second layer 432, respectively. The material layers may have lattice constants that are different from that of InP by about 2% or more so that dislocations from the underlying layer bend toward a lateral direction or counterbalance each other at the interfaces 432a and 432b, thereby suppressing the upward propagation of the dislocations. As shown in FIG. 4, a dislocation density D concentrates in the first layer 431 that is the lowermost layer in the buffer layer 430, and decreases toward upper layers so that little defect is present in the uppermost layer of the buffer layer 430.

A high quality group III-V compound semiconductor material may be formed by using the above-described substrate structure 400, and used as a device layer to form various electronic devices and optical devices. Examples of the device layer may include a light emitting diode (LED), a laser diode (LD), a photo diode (PD), a field effect transistor (FET), a high electron mobility transistor (HEMT), and a Schottky diode structure.

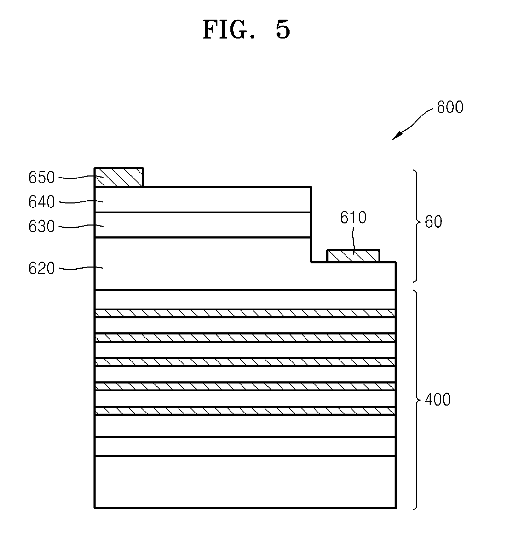

FIG. 5 is a schematic cross-sectional view of a semiconductor device according to example embodiments.

A semiconductor device 600 according to example embodiments includes the substrate structure 400 and a device layer 60 that is formed on the substrate structure 400 and includes a group III-V compound semiconductor layer. While the substrate structure 400 is configured as shown in FIG. 4, example embodiments are not limited thereto. In other words, one of the substrate structures 100, 200, and 300 of FIGS. 1 through 3 may be used instead of the substrate structure 400.

The device layer 60 constructs an LED, and includes a first-type semiconductor layer 620, an active layer 630, and a second-type semiconductor layer 640. A first electrode 610 and a second electrode 650 are disposed on the first- and second-type semiconductor layers 620 and 640, respectively, to apply a current to the active layer 630 so that electrons and holes recombine at the active layer 630 to produce light.

The first semiconductor layer 620 is doped with a first type and may be formed of a group III-V compound semiconductor material. For example, the group III-V compound semiconductor material may be doped with n-type impurities such as silicon (Si), germanium (Ge), selenium (Se), and tellurium (Te).

The second-type semiconductor layer 640 is doped with a second type and may be formed of a group III-V compound semiconductor material. For example, the group III-V compound semiconductor material may be doped with p-type impurities such as magnesium (Mg), zinc (Zn), and beryllium (Be).

The active layer 630 emits light due to recombination of electrons and holes. Energy corresponding to an energy band gap of the active layer 630 may be released in the form of light. The active layer 630 may have a single quantum well (SQW) or multi quantum well (MQW) structure.

Although the first- and second-type semiconductor layers 620 and 630 have a single layer structure, they may have a multi-layer structure.

Although the semiconductor device 600 is an LED, a photo diode for producing an electrical signal in response to incident light, or a laser diode made by further including a resonant cavity structure to the LED structure may be used as the semiconductor device 600.

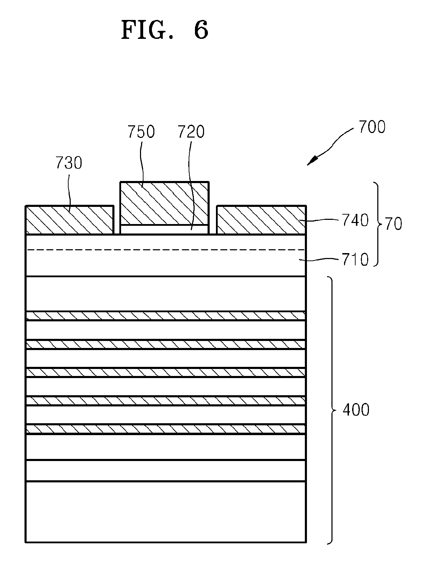

FIG. 6 is a schematic cross-sectional view of a semiconductor device according to other example embodiments.

Referring to FIG. 6, a semiconductor device 700 according to the present example embodiments includes the substrate structure 400 and a device layer 70 that is formed on the substrate structure 400 and includes a group III-V compound semiconductor layer. While the substrate structure 400 is configured as shown in FIG. 4, example embodiments are not limited thereto. In other words, one of the substrate structures 100, 200, and 300 of FIGS. 1 through 3 may be used instead of the substrate structure 400.

The device layer 70 constructs a thin film transistor (TFT) and includes a channel layer 710, a source electrode 730 and a drain electrode 740 contacting two ends of the channel layer 710, and a gate insulating layer 720 on the channel layer 710, and a gate electrode 750 on the gate insulating layer 720.

The channel layer 710 has a plurality of layers, e.g., a dual layer structure of indium aluminum arsenide (InAIAs)/InGaAs.

Furthermore, the substrate structure 400 may be used in the form of an optoelectronic integrated circuit (OEIC) where silicon-based electronic or optical devices and group III-V compound optical devices are integrated into a single device.

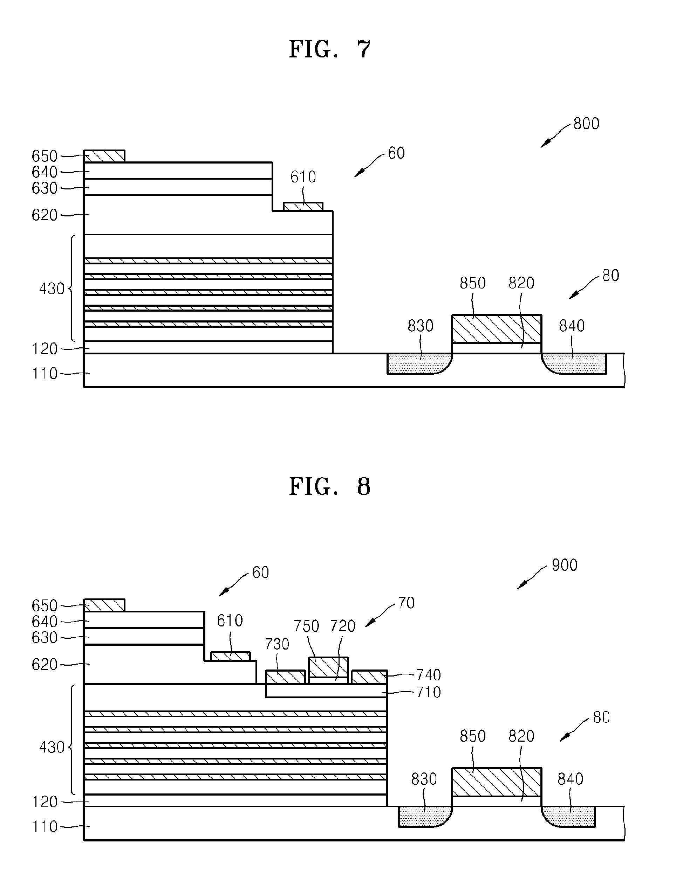

FIG. 7 is a schematic cross-sectional view of a semiconductor device according to other example embodiments.

Referring to FIG. 7, a semiconductor device 800 according to the present example embodiments includes a nucleation layer 120 that is formed on one region of a silicon substrate 110 and of a group III-V compound semiconductor material having a lattice constant that is different from that of the silicon substrate 110 by less than 1%, a buffer layer 430 having two layers of group III-V compound semiconductor materials stacked alternately, wherein the two layers have lattice constants that are different from that of the nucleation layer 120 by 4% or more, a device layer 60 on the buffer layer 430, and a silicon device 80 formed on another region of the silicon substrate 110.

As shown in FIG. 7, the silicon device 80 has a transistor structure and includes a source region 830 and a drain region 840 formed by doping a region of the silicon substrate 110 at high concentration, a gate insulating layer 820 on the silicon substrate 110, and a gate electrode 850 on the gate insulating layer 820.

FIG. 8 is a schematic cross-sectional view of a semiconductor device 900 according to another embodiment of the present invention.

Referring to FIG. 8, the semiconductor device 900 according to the present embodiment includes a nucleation layer 120 that is formed on one region of a silicon substrate 110, a buffer layer 430 on the nucleation layer 120, a device layer 60 having an LED structure and a device layer 70 having a transistor structure, which are formed on the buffer layer 430, and a silicon device 80 formed on another region of the silicon substrate 110.

The semiconductor devices 800 and 900 of FIGS. 7 and 8 are silicon-based photonics integrated circuits (PICs), and the silicon device 80 integrated with a group III-V compound optical device in the semiconductor device 800 or 900 may include various optical elements such as an optical coupler, an optical modulator, and an optical waveguide in addition to the silicon transistor.

The above-described substrate structures according to one or more embodiments of the present invention include a nucleation layer and a buffer layer on a substrate and are configured so that defects due to a lattice constant difference between the substrate and the buffer layer concentrate on the buffer layer and counterbalance and annihilate each other in the buffer layer.

Furthermore, when the nucleation layer is formed of a group III-V compound semiconductor material having a lattice constant that is slightly different from that of the substrate, small-sized and uniform nucleation may occur, thereby providing a high quality group III-V compound nucleation layer.

By using the nucleation layer and the buffer layer having the above-described structures, a large-area semiconductor device including a group III-V compound semiconductor layer having slight defects such as dislocations on a silicon substrate may be provided.

The group III-V compound semiconductor layer formed on the above-described substrate structure may be used as various optical devices and electronic devices to thereby easily realize a silicon-based photonics integrated circuits.

While the present invention has been particularly shown and described with reference to exemplary embodiments thereof to aid in the understanding thereof, it will be understood that the exemplary embodiments described therein should be considered in a descriptive sense only and not for purposes of limitation, and the scope of the invention is not defined by the detailed description of the invention. Furthermore, it will be understood by those of ordinary skill in the art that various changes in form and details may be made therein without departing from the scope of the present invention as defined by the following claims.

## Claims

1. A substrate structure, comprising:
a substrate;
a nucleation layer on the substrate and including a first group III-V compound semiconductor material having a lattice constant that is different from a lattice constant of the substrate by less than 1 %; and
a buffer layer on the nucleation layer and including first and second layers,
wherein the first layer includes a second group III-V compound semiconductor material, and the second layer includes a third group III-V compound semiconductor material, and
the second group III-V compound semiconductor material and the third group III-V compound semiconductor material have lattice constants that are greater than the lattice constant of the first group III-V compound semiconductor material included in the nucleation layer by 4% or more.

2. The substrate structure of claim 1, wherein the nucleation layer includes at least one selected from the group consisting of gallium phosphide (GaP), aluminum phosphide (AIP), gallium aluminum phosphide (GaxAl1-xP,), gallium nitrogen phosphide (GaNP), and gallium nitrogen arsenic phosphide (GaNAsP), and/or wherein the buffer layer is formed of one selected from the group consisting of InP, gallium arsenide (GaAs), indium arsenide (InAs), gallium antimonide (GaSb), and indium antimonide (InSb), and a combination thereof.

3. The substrate structure of claim 1 or 2, wherein a difference between lattice constants of the first and second layers of the buffer layer is less than 1 %.

4. The substrate structure of any of claims 1-3, wherein:
the buffer layer further includes a third layer on the second layer, and
the third layer includes a fourth group III-V compound semiconductor material having a lattice constant that is different from the lattice constant of the third group III-V compound semiconductor material included in the second layer by less than 1%.

5. The substrate structure of claim 4, wherein:
the second layer is made of the third group III-V compound semiconductor material,
the third layer is made of the fourth group III-V compound semiconductor material, and
a group V element in the third group III-V compound semiconductor material is different from a group V element in the fourth group III-V compound semiconductor material.

6. The substrate structure of claim 4 or 5, wherein the buffer layer has a structure in which the second and third layers are alternately stacked at least two times on each other.

7. The substrate structure of claim 6, wherein:
the buffer further comprises a material layer at an interface between the second and third layers,
a difference between a lattice constant of the material layer and a lattice constant of the second layer is larger than a difference between the lattice constant of the second layer and the lattice constant of the third layer, and
a difference between the lattice constant of the material layer and a lattice constant of the third layer is larger than the difference between the lattice constant of the second layer and the lattice constant of the third layer.

8. The substrate structure of any of claims 4-7, wherein one of the second and third layers is indium phosphide (InP), and the other one is indium gallium arsenide (InGaAs).

9. The substrate structure of any of claims 1-8, wherein:
the first layer is made of the second group III-V compound semiconductor material,
the second layer is made of the third group III-V compound semiconductor material, and
a group V element in the second group III-V compound semiconductor material is different from a group V element in the third group III-V compound semiconductor material.

10. The substrate structure of claim 9, wherein the buffer layer has a structure in which the first and second layers are alternately stacked at least two times on each other.

11. The substrate structure of claim 10, wherein the buffer layer further comprises a material layer at an interface between the first and second layers,
wherein a difference between a lattice constant of the material layer and the lattice constant of the first layer is larger than the difference between the lattice constant of the first layer and the lattice constant of the second layer, and
wherein a difference between the lattice constant of the material layer and the lattice constant of the second layer is larger than the difference between the lattice constant of the first layer and the lattice constant of the second layer.

12. The substrate structure of claim 11, wherein one of the first and second layers is InP, and the other one is InGaAs.

13. The substrate structure of any of claims 1-12, wherein the substrate is a silicon substrate.

14. A semiconductor device comprising:
a substrate according to any of claims 1-13;
and
a device layer on the buffer layer, wherein the device layer includes a group III-V compound semiconductor layer.

15. The semiconductor device of claim 14, wherein the device layer includes one selected from the group consisting of a light emitting diode (LED), a laser diode (LD), a photo diode (PD), a field effect transistor (FET), a high electron mobility transistor (HEMT), and a Schottky diode structure.

16. The semiconductor device of claim 15, further comprising:
a silicon-based electronic device or optical device on the silicon substrate.
